# EUROPEAN PATENT APPLICATION

(11) **EP 3 418 265 A1**
(43) Date of publication of application: **26.12.2018**
(21) Application number: 17177110.8
(22) Date of filing: 21.06.2017
(51) Int. Cl.: C04B 37/02, H01L 23/15, H01L 21/48, H01L 23/00, H01L 25/07, H01L 21/02, H05K 1/03, H05K 3/40

(54) **LOGIC POWER MODULE WITH A THICK-FILM PASTE MEDIATED SUBSTRATE BONDED WITH METAL OR METAL HYBRID FOILS**

(71) Applicant: Heraeus Deutschland GmbH & Co. KG, 63450 Hanau (DE)
(72) Inventor: MIRIC, Anton, 63755 Alzenau (DE); RAUER, Miriam, 63743 Aschaffenburg (DE); HERBST, Kai, 91056 Erlangen (DE); JUNG, Christian, 96173 Oberhaid (DE)
(74) Representative: Gille Hrabal

(57) **Abstract**

A logic power module, comprising at least one logic component, at least one power component and a substrate, whereby the logic element and the power component are provided in separate areas on the substrate is described. The logic component on the substrate is provided by thick printed copper; and the power component is provided by a metal-containing thick-film layer, and, provided thereon, a metal foil.

## Description

The present invention relates to a logic power module, comprising at least one logic component, at least one power component and a substrate, whereby the logic component and the power component are provided in separate areas on the substrate.

Moreover, the present invention relates to a process for the preparation of said logic power module and to the use of said logic power module.

Logic power modules can be built as completely independent parts, the power modules usually made on a DCB-Al₂O₃ substrate (Direct Copper Bonding), on a DCB-AIN-substrate, on a DCB-Si₃N₄-substrate or on an IMS-substrate (insulated metal substrate) and the logic modules are manufactured on epoxy PCB or by using thick film techniques. By using this thick film technology, many possible different thicknesses of the logic modules can be prepared. In some cases thick logic modules in the range of about 300 µm thickness and slightly thinner logic modules in the range of about 10 µm thickness can be prepared on the same substrate. Moreover, the thick film technique allows to print conductive and non-conductive multilayers and top of each other whereby the conductive layers can be connected by so-called vias.

In an alternative, combined electronic logic and power modules are known, in which logic and power components are each constructed on a thick-film substrate. These combined electronic and power modules are described, for example, in EP 0 751 570A.

The power component of these logic and power modules are usually prepared by the so-called DCB-technology. Direct copper bonded (DCB) substrates are commonly used in power modules because of their very good thermal conductivity. They are composed of a ceramic tile (commonly alumina) with a sheet of copper bonded to one or both sides by a high-temperature oxidation process (the copper and substrate are heated to a carefully controlled temperature in an atmosphere of nitrogen containing about 30 ppm of oxygen; under these conditions, a copper-oxygen eutectic forms which bonds successfully both to copper and the oxides used as substrates). The top copper layer can be preformed prior to firing or chemically etched using printed circuit board technology to form an electrical circuit, while the bottom copper layer is usually kept plain. The substrate is attached to a heat spreader by soldering the bottom copper layer to it.

In the DCB technology, a copper foil is bonded onto a ceramic substrate with a eutectic melt. This process technology suffers from some disadvantages, such as a high amount of rejects, the creation of cavities between the ceramic substrate and the copper foil and the relatively low resistance against temperature changes (which leads to a delamination after some thermic cycles). A respective technology is described, for example, in DE 10 2010 025 313 A in which a mixture of the metal and an oxide of this metal is applied on a ceramic substrate which is then bonded via a DCB process. On the other hand, substrates, which are prepared based on the thick print technology, are also known. These substrates have the disadvantage of high production costs and low electronic and thermal conductivity caused by the porosity of the sintered layers.As a solution of this problem, the unpublished prior patent application PCT/EP2016/082161 propose a metal ceramic substrate which is prepared by applying of a thick-film paste onto a ceramic substrate; applying of a metal foil onto the thick-film layer of the ceramic substrate; and bonding of the metal foil with the ceramic substrate via the thick-film layer. This metal ceramic substrate exhibits an improved stability (i.e., a reduced risk of delamination), a high conductivity and a high durability and can be produced with reduced costs. However, the unpublished prior patent application PCT/EP2016/082161 does not disclose the use of the underlying technology in the field of logic power modules.

The present invention now provides a further application of the technology underlying PCT/EP2016/082161 and provides logic power modules that comprises a logic component and a power component on one substrate, whereby the power component is prepared by the modified DCB technology as described in the unpublished prior patent application PCT/EP2016/082161.

Accordingly, the present invention relates to a logic power module, comprising at least one logic component, at least one power component and a substrate, whereby the logic element and the power component are provided in separate areas on the substrate.

The logic power module according to the present invention is characterized in that
(a) the logic component on the substrate is provided by thick printed metal; and
(b) the power component is provided by a metal-containing thick-film layer and, provided thereon, a metal foil.

In the present invention, the logic component relates to the part of the power logic module which comprises, inter alia, conductors for digital and analog signals, die attach structures (on, for example, chips are provided), and passive electronic components, such as resistors, capacitors etc.

In the present invention, thick-printed metal means in particular thick-printed copper and thick-printed silver, whereby thick-printed copper is preferred.

The present arrangement of the logic power module according to the present invention possess several advantages over the commonly known logic power modules as outlined in the following:
Based on the modified DCB technology, by which the power component is provided by a metal-containing thick-film layer and, provided thereon, a metal foil, the combination of the logic component and a power component can be realized on the same substrate cheaper as compared with common known logic power modules. Moreover, it is possible to realize thicker metallization as compared with the technology of thick printed copper, whereby an improved heat dissipation (heat sink) and higher current-carrying capacity (ampacity) is achieved. Using the multilayer constitution of the logic power module according to the present invention, mounted parts with minimum inductance values for the power component as for the logic component become possible. By using the low-inductance power pathway it becomes possible to switch higher voltages and the complete system can be used with a higher overall performance. The low-inductive logic pathway allows to improve the switch frequency, the logic elements can detect faults and react thereto earlier. This is in particular preferable in case of semiconductors with a wide band gap, for example SiC and GaN, since these semiconductors switch fast. The multilayer constitution consists of conducting paths and isolators and can be provided on the substrate surface which is provided with the copper foil or non-covered.

Furthermore, the present invention allows to print the thick metal layer of the logic component and the metal-containing thick film layer of the power component in one process step (i.e., at the same time) which facilitates the production of the logic power module according to the present invention.

Moreover, the technology described in the unpublished prior patent application PCT/EP2016/082161 allows, as compared with common DCB substrates, lower deflections respectively the use of thinner substrates or the use of thicker copper layers, which lowers the thermal resistance and increases the thermal capacity.

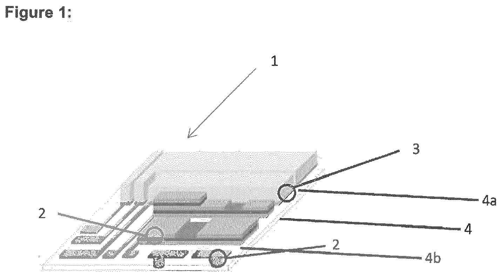

The logic power module according to the present invention is shown in figure 1. In this figure, reference number 1 stands for the logic power module, the reference number 2 stands for the logic component, the reference number 3 stands for the power component, the reference number 4 stands for the substrate, on which the area of the logic component is designated with the reference number 4a, while the area of the power component is designated with the reference number 4b.

As already outlined above, the logic power module 1 according to the present invention comprises one logic component 2 and at least one power component 3 on the same ceramic substrate. In the following both parts, the logic component 2 and the power component 3, are described in more detail.

### The logic component

The logic component 2 of the logic power module according to the present invention may be prepared by an electroconductive paste, preferably a copper paste, which is deposited, dried and sintered, preferably by firing. The process of firing can be carried out in a protective atmosphere, such as a nitrogen atmosphere or argon atmosphere.

By the deposition process logic components are formed.

In the sense of the present invention, the thick printed metal paste can be provided on the ceramic substrate by a single printing step or by several printing steps, whereby in case of several printing steps the same thick film metal paste or different thick printed metal pastes can be used. Moreover, it is possible to arrange an dielectric layer between the thick printed metal paste layers. In case of conductive and dielectric stack layers, conductive layers can be connected electrically to each other by so-called vias.

In one specific embodiment of the present invention a single thick film metal paste is used in one or several printing steps.

In a further embodiment, the logic component can be provided by different thick printed metal pastes, which are provided by individual printing steps.

In this case, it is possible to distinguish the electroconductive metal paste, preferably copper paste, in a base layer composition and a top layer composition. The base layer composition is typically applied directly onto the substrate, and provides optimal adhesion to the ceramic substrate. The top layer composition is typically applied over a fired base layer composition layer or another fired top layer composition layer. Multiple layers of the top layer composition may be applied in order to build the metal conductor, preferably copper conductor, to a desired thickness on the substrate in the logic area.

Accordingly, a base layer electroconductive metal paste composition, preferably a copper paste composition, may be first deposited on the ceramic substrate, dried and sintered, preferably fired. Subsequent layer(s) of top layer electroconductive metal paste composition, preferably copper paste composition. may be deposited on the fired base layer or previously fired top layer to build up the metal conductor to a desired thickness.

It is also possible that the base layer electroconductive metal paste, preferably electroconductive copper paste, is deposited on the ceramic substrate, dried and subsequent layer(s) of metal paste, preferably copper paste, are printed thereon without prior sintering, preferably firing, of the underlying paste layer(s). Each layer may be dried before printing the subsequent layer. The layers may be sintered, preferably fired, in a final step to form the metal conductor(s) in the desired thickness.

The electroconductive metal paste compositions, preferably the copper paste compositions. may be applied to the ceramic substrate via screen printing, stencil printing, direct deposition, or any other means known to one skilled in the art. The preferred application method is screen printing. Typically, a stainless steel mesh screen with an emulsion layer comprising the predetermined circuitry is employed for the screen printing process.

The printed electroconductive metal paste compositions, preferably copper paste compositions, are typically dried at a moderate temperature to prevent the oxidation of the metal particles. Typically, the drying temperature is about 100 to 130 °C, preferably 125 °C, and the drying time is about 5 to 15 min.

The firing of the electroconductive metal paste compositions, preferably copper paste compositions, and ceramic substrate are typically conducted in a furnace at about 850 to 1050 °C, preferably 925 to 950 °C, peak temperature in a low oxygen atmosphere, such as a nitrogen atmosphere with an O₂ content typically below 10 to 20 ppm, preferably about 1 to 3 ppm, O₂. Typically, the dwelling time at peak firing temperature is about 5 to 10 min, preferably 8 to 10 min.

In one embodiment, the logic component may be prepared on a ceramic substrate using the electroconductive metal pastes, preferably the copper pastes, by a process comprising:
(i) depositing a first layer of base layer electroconductive paste, preferably a copper paste, on a ceramic substrate;
(ii) optionally drying the ceramic substrate with the deposited base layer electroconductive paste, preferably the copper paste, at a temperature at about 100 to about 125°C for about 5 to about 10 minutes;
(iii) optionally subjecting the deposited base layer electroconductive paste, preferably the copper paste, and the ceramic substrate to a temperature of about 900 to about 1000 °C in a nitrogen atmosphere comprising from about 1 to about 20 ppm oxygen;
(iv) optionally depositing a second layer of a electroconductive paste as a top layer, preferably a copper paste, on the ceramic substrate;
(v) optionally drying the ceramic substrate with the deposited top layer electroconductive paste, preferably the copper paste, at a temperature at about 100 to about 125°C for about 5 to about 10 minutes; and
(vi) subjecting the deposited layers and the ceramic substrate to a temperature of about 900 to about 1000 °C in a nitrogen atmosphere comprising from about 1 to about 20 ppm oxygen.

The process defined above can further comprise a or more step(s) of depositing further electroconductive layer(s), in particular copper layer(s), and/or a dielectric layer(s).

The metal conductor in the logic component may be built to the desired thickness by repeating the steps (iv) to (vi). The fired thickness of the metal conductor is about 10 to 75 µm, preferably 15 to 50 µm, for each layer of electroconductive metal paste. For example, steps (iv) to (vi) may be repeated 1 to 10 times. A metal conductor in the logic component of a fired thickness of about 300 µm can be achieved with one layer of base layer paste and up to ten layers of top layer paste.

The electroconductive paste composition used for the logic component may comprise a glass frit, whereby the base layer electroconductive paste composition may comprise a higher amount of glass frit than the top layer electroconductive paste composition. In a preferred embodiment, the base layer electroconductive paste comprises from about 1 to about 5 wt. % of glass frit. In another preferred embodiment, the top layer electroconductive paste comprises preferably of from 0 to 20 wt.-%, more preferably 0 to 5 wt.-%,of glass frit.

The electroconductive paste composition used for the logic component may also comprise no glass frit.

The electroconductive paste composition used for the logic component comprises usually an adhesion promoter, whereby the base layer may comprise a higher amount of adhesion promoter than the top layer electroconductive paste composition. In a preferred embodiment, the base layer electroconductive paste comprises from about 1 to about 5 wt. % of adhesion promoter, preferably from about 2 to about 4 wt. %, more preferably about 3 wt. % of adhesion promoter. In a preferred embodiment, the top layer electroconductive paste comprises from about 0.25 to about 1.25 wt. % of adhesion promoter, preferably from about 0.75 to about 1.25 wt. %, more preferably about 1 wt. % of adhesion promoter.

The thick-film paste used for the logic component may comprise copper as a metal and optionally Bi₂O₃.

The electroconductive paste comprises preferably 40 to 92 wt.-% copper, more preferably 40 to less than 92 wt.-% copper, more preferably 70 to less than 92 wt.-% copper, most preferably 75 to 90 wt.-% copper, each based on the total weight of the electroconductive paste.

The electroconductive paste comprises preferably 0 to 50 wt.-% Bi₂O₃, more preferably 1 to 20 wt.-% Bi₂O₃, most preferably 2 to 15 wt.-% Bi₂O₃, each based on the total weight of the electroconductive.

The copper particles used in the electroconductive paste have a median diameter (d₅₀) preferably of between 0.1 to 20 µm, more preferably of between 1 and 10 µm, most preferably of between 2 and 7 µm.

The Bi₂O₃ particles used optionally in the electroconductive paste have a median diameter (d₅₀) preferably of less than 100 µm, more preferably of less than 20 µm, most preferably of less than 10 µm.

In a further embodiment of the present invention, the electroconductive paste may comprise copper and a glass component as already mentioned above.

The amount of copper in the electroconductive paste in case of a simultaneous use of a glass component might be as defined above, i.e. preferably in an amount of from 40 to 92 wt.-%, more preferably 40 to less than 92 wt.-% copper, more preferably in an amount of from 70 to less than 92 wt.-% copper, most preferably in an amount of from 75 to 90 wt.-% copper, each based on the total weight of the electroconductive paste.

In the case of use of a glass component in the electroconductive paste, the electroconductive paste comprises preferably of from 0 to 20 wt.-%, more preferably 0 to 5 wt.-%, of the glass component, each based on the total weight of the thick-film paste.

In the case of use of a glass component in the thick-film paste, the copper particles may have the same median diameter (d₅₀) as already mentioned above, i.e. preferably of between 0.1 to 20 µm, more preferably of between 1 and 10 µm, most preferably of between 2 and 7 µm.

In the case of use of a glass component in the electroconductive paste, the glass component particles may have a median diameter (d₅₀) of less than 100 µm, more preferably less than 20 µm, most preferably less than 10 µm.

The electroconductive paste, preferably on the basis of copper, may comprise - besides the glass component and Bi₂O₃ - further components, selected from the group consisting of PbO, TeO₂, Bi₂O₃, ZnO, B₂O₃, Al₂O₃, TiO₂, CaO, K₂O, MgO, Na₂O, ZrO₂, Cu₂O, CuO and Li₂O.According to another embodiment, the assembly is fired in an inert (e.g., nitrogen) atmosphere according to a specific profile. If a metal conductive paste, preferably a copper conductive paste, is fired in an environment too rich in oxygen, the metal component may begin to oxidize. However, a minimum level of oxygen is required to facilitate burnout of the organic binder in the paste. Therefore, the level of oxygen must be optimized. According to a preferred embodiment of the invention, approximately 1 to 20 ppm of oxygen is present in the furnace atmosphere. More preferably, approximately 1 to 10 ppm of oxygen is present in the furnace atmosphere, and most preferably, approximately 1 to 3 ppm of oxygen is present.

Preferred electroconductive paste composition are commercially available from Heraeus (thick film conductor systems, e.g. C7403 and C7404 series).

### The power component

The power component 3 is provided on the ceramic substrate of the logic power module 1 by a metal-containing thick-film layer, and, provided thereon, a metal foil.

This power component 3 can be prepared, in a first aspect, by the following process steps:
(1.1) applying of a thick-film paste onto the ceramic substrate;
(1.2) applying of a metal foil onto the thick-film layer of the ceramic substrate; and
(1.3) bonding of the metal foil with the ceramic substrate via the thick-film layer.

Accordingly, the structure of the power component 3 comprises
(a) the ceramic substrate and, provided thereon,
(b) the metal-containing thick-film layer, and, provided thereon;
(c) the metal foil.

According to the present invention, it has been found out that based on the thick-film technology it is possible to provide a substrate for use in the field of power electronics in which a metal foil is bonded via a thick-film paste of a metal onto a ceramic substrate (such as Al₂O₃ ceramic, AIN ceramic or Si₃N₄ ceramic). The resulting metal-ceramic-substrates have a high conductivity and durability and can be produced with reduced costs.

At first, the process for preparing the power component 3 of the logic power module is described. Thereby, the process for the preparation of the power component 3 can be carried out in two embodiments:

### First embodiment - applying the thick-film on the ceramic substrate 4 in the area of the power component 4b:

The thick-film paste is applied onto the ceramic substrate in the area 4b of the ceramic substrate 4 where the resulting logic power module 1 has to to comprise the power component 3 in the first process step.

In a *first aspect,* the thick-film paste can be applied onto the ceramic substrate 4 discontinuously such that the thick-film paste is only applied on those parts of the ceramic substrate 3, which correspond to an intended electronic circuit of the final metal-ceramic substrate.

The metal foil may be applied, thereafter, continuously over the whole thick-film layer of the ceramic substrate 4 in the area of the power component 4b. After that, the metal foil is bonded with the ceramic substrate and then structured, for example by etching.

In this first aspect, the metal foil may also be applied discontinuously over the thick-film layer only on those parts of the ceramic substrate on which the thick-film paste is applied.

In a *second aspect,* the thick-film paste is applied continuously onto the ceramic substrate 4 in the area of the power component 4b.

Then, the metal foil may be applied continuously over the whole thick-film layer of the ceramic substrate 4 in the area of the power component 4b and the metal foil and the thick-film layer are structured, for example, by etching after bonding.

The metal foil may also be applied discontinuously only on those parts of the ceramic substrate 4 in the area of the power component 4b which correspond to an intended electronic circuit of the final logic power module 1. In this case, the thick-film layer is structured, for example, by etching after bonding.

After applying the thick-film paste onto the ceramic substrate, the thick-film paste may be air-dried prior to applying the metal foil onto the thick-film layer.

After applying the thick-film paste onto the ceramic substrate 4 in the area of the power component 4b, the thick-film paste may also be sintered prior to applying the metal foil. Such a sintering process can be carried out by a temperature of below 1025 °C. Preferably, the sintering process is carried out by a temperature in the range of from 300 to 1025 °C, more preferably in the range of from 600 to 1025 °C, more preferably in the range of from 900 to 1025 °C, more preferably in the range of from 900 to less than 1025 °C, more preferably in the range of from 900 to 1000 °C.

Sintering / firing the electroconductive paste removes organic components from the wet film and ensures a good bonding of the thick film copper to the substrate. In contrast to the standard DCB process, adhesion of the fired electroconductive film is established well below the Cu-O eutectic melting temperature. Bonding of bulk Cu foils to this fired electroconductive film is then carried out by a pure metal to metal sintering process. Accordingly, this process differs from the one described e.g in DE 10 2010 025 313 A.

After applying the thick-film paste onto the ceramic substrate, the thick-film paste may also be air-dried and sintered prior to applying the metal foil onto the thick-film layer. The sintering conditions are as described above.

The sintering process of the applied thick-film paste is usually carried out under an inert atmosphere, such as a nitrogen atmosphere.

### Second embodiment - applying the thick-film on the metal foil

In a further modified process for preparing the power component 3 of the logic power module 1, the modified claimed process comprises the following process steps:
(2.1) applying of the thick-film paste onto the metal foil;
(2.2) applying of the area 4b of the power component 3 of the ceramic substrate 4 onto the thick-film layer of the metal foil; and
(2.3) bonding the metal foil with the ceramic substrate 4 via the thick-film layer.

In this modified process, the thick-film paste may be coated onto the metal foil substrate by screen printing.

After applying the thick-film paste onto the metal foil, the thick-film paste may be air-dried prior to applying the metal foil onto the ceramic in the area 4b of the power component 3.

In the modified process according to the present invention, the metal foil and the thick-film paste are structured by etching before or after bonding the metal foil onto the ceramic substrate via the thick-film layer.

The following explanations are given for both embodiments described above:
The thick-film paste may be applied onto the ceramic substrate 4 in the area 4b of the power component 3 or the metal foil by multilayer printing. If a process step of multilayer coating is applied and the thick-film paste is applied onto the ceramic substrate 4, the first coating of the multilayer coating may be provided with lines for contacts.

In both processes for preparing the power component 3 of the logic power module 1, i.e. the first and second embodiment, the bonding steps (1.3) and/or (2.3) are carried out by firing. Usually, the firing is carried out at a temperature of between 750 and 1100 °C, more preferably of between 800 and 1085 °C, even more preferably of between 900 and 1085 °C. In these bonding steps the metal foil is bonded via the thick-film paste to the ceramic substrate in the area of the power component 4b basically not by applying the DCB process since the metal foil is in contact with the layer provided by the thick-film paste and not with the ceramic substrate 3.

The metal foil may be oxidized before bonding to the ceramic substrate 4 in the area of the power component 4b via the thick-film layer in both embodiments described above. In another embodiment, the metal foil is not oxidized before bonding to the ceramic substrate 4 via the thick-film layer.

In a further modification of both embodiments, the thick-film layer may be oxidized before bonding of the metal foil onto the ceramic substrate 4. In another embodiment, the thick-film layer is not oxidized before bonding of the metal foil onto the ceramic substrate 4.

The process steps (1.3) and/or (2.3) of bonding the metal foil onto the ceramic substrate 4 may be carried out under pressure.

In both embodiments described above, the metal foil is preferably a copper foil.

In the following, the thick-film paste, which can be used in the process according to both embodiments described above, is described in more detail:
The thick-film paste used in the process according to the present invention (either in the normal process or in the modified process) may comprise copper as a metal and optionally Bi₂O₃.

The thick-film paste comprises preferably 40 to 92 wt.-% copper, more preferably 40 to less than 92 wt.-% copper, more preferably 70 to less than 92 wt.-% copper, most preferably 75 to 90 wt.-% copper, each based on the total weight of the thick-film paste.

The thick-film paste comprises preferably 0 to 50 wt.-% Bi₂O₃, more preferably 1 to 20 wt.-% Bi₂O₃, most preferably 2 to 15 wt.-% Bi₂O₃, each based on the total weight of the thick-film paste.

The copper particles used in the thick-film paste have a median diameter (d₅₀) preferably of between 0.1 to 20 µm, more preferably of between 1 and 10 µm, most preferably of between 2 and 7 µm.

The Bi₂O₃ particles used optionally in the thick-film paste have a median diameter (d₅₀) preferably of less than 100 µm, more preferably of less than 20 µm, most preferably of less than 10 µm.

In a further embodiment of the present invention, the metal-containing thick-film paste may comprise copper and a glass component.

The amount of copper in the thick-film paste in case of a simultaneous use of a glass component might be as defined above, i.e. preferably in an amount of from 40 to 92 wt.-%, more preferably 40 to less than 92 wt.-% copper, more preferably in an amount of from 70 to less than 92 wt.% copper, most preferably in an amount of from 75 to 90 wt.-% copper, each based on the total weight of the thick-film paste.

In the case of use of a glass component in the thick-film paste, the thick-film paste comprises preferably of from 0 to 50 wt.-%, more preferably 1 to 20 wt.-%, most preferably 2 to 15 wt.-%, of the glass component, each based on the total weight of the thick-film paste.

In the case of use of a glass component in the thick-film paste, the copper particles may have the same median diameter (d₅₀) as already mentioned above, i.e. preferably of between 0.1 to 20 µm, more preferably of between 1 and 10 µm, most preferably of between 2 and 7 µm.

In the case of use of a glass component in the thick-film paste, the glass component particles may have a median diameter (d₅₀) of less than 100 µm, more preferably less than 20 µm, most preferably less than 10 µm.

The metal-containing thick-film paste, preferably on the basis of copper, may comprise - besides the glass component and Bi₂O₃ - further components, selected from the group consisting of PbO, TeO₂, Bi₂O₃, ZnO, B₂O₃, Al₂O₃, TiO₂, CaO, K₂O, MgO, Na₂O, ZrO₂, Cu₂O, CuO and Li₂O.

Preferred electroconductive paste composition are commercially available from Heraeus for standard applications in thick film technology (thick film conductor systems, e.g. C7403 and C7404 series).After applying the thick-film paste either onto the ceramic substrate 4 or onto the metal foil, the layer thickness is preferably of from 5 to 150 µm, more preferably of from 20 to 125 µm, most preferably of from 30 to 100 µm.

In a preferred embodiment of the present invention, the amount of copper oxide in the thick-film paste is less than 2 wt.-%, more preferably less than 1.9 wt.-%, more preferably less than 1.8 wt.-%, more preferably less than 1.5 wt.-%.

In the following, the power component 3 on the ceramic substrate 4 is described in more detail. This power component 3 comprises
(a) a ceramic substrate 4 and, provided thereon,
(b) a metal-containing thick-film layer, and, provided thereon,
(c) a metal foil.

The metal foil and/or the metal-containing thick-film layer may be structured.

The thick-film layer, provided onto the ceramic substrate, comprises preferably copper as a metal and optionally Bi₂O₃.

The thick-film paste comprises preferably 40 to 92 wt.-% copper, more preferably 40 to less than 92 wt.-% copper,more preferably 70 to less than 92 wt.-% copper, most preferably 75 to 90 wt.-% copper, each based on the total weight of the thick-film paste.

The thick-film paste comprises preferably 0 to 50 wt.-% Bi₂O₃, more preferably 1 to 20 wt.-% Bi₂O₃, most preferably 2 to 15 wt.-% Bi₂O₃, each based on the total weight of the thick-film paste.

The copper particles used in the thick-film paste have a median diameter (d₅₀) preferably of between 0.1 to 20 µm, more preferably of between 1 and 10 µm, most preferably of between 2 and 7 µm.

The Bi₂O₃ particles used optionally in the thick-film paste have a median diameter (d₅₀) preferably of less than 100 µm, more preferably of less than 20 µm, most preferably of less than 10 µm.

In a further embodiment of the present invention, the metal-containing thick-film paste may comprise copper and a glass component.

The amount of copper in the thick-film paste in case of a simultaneous use of a glass component might be as defined above, i.e. preferably in an amount of from 40 to 92 wt.-%, more preferably in an amount of from 70 to 92 wt.-% copper, most preferably in an amount of from 75 to 90 wt.-% copper, each based on the total weight of the thick-film paste.

In the case of use of a glass component in the thick-film paste, the thick-film paste comprises preferably of from 0 to 50 wt.-%, more preferably 1 to 20 wt.-%, most preferably 2 to 15 wt.-%, of the glass component, each based on the total weight of the thick-film paste.

In the case of use of a glass component in the thick-film paste, the copper particles may have the same median diameter (d₅₀) as already mentioned above, i.e. preferably of between 0.1 to 20 µm, more preferably of between 1 and 10 µm, most preferably of between 2 and 7 µm.

In the case of use of a glass component in the thick-film paste, the glass component particles have may have a median diameter (d50) of less than 100 µm, more preferably less than 20 µm, most preferably less than 10 µm.

The metal-containing thick-film paste may comprise - besides the glass component and Bi₂O₃ - further components, selected from the group consisting of PbO, TeO₂, Bi₂O₃, ZnO, B₂O₃, Al₂O₃, TiO₂, CaO, K₂O, MgO, Na₂O, ZrO₂, Cu₂O, CuO and Li₂O.

The layer thickness of the thick-film paste is preferably 10 to 150 µm, more preferably 20 to 125 µm, most preferably 30 to 100 µm.

The metal foil is preferably a copper foil.

The thick-film paste of the power component and the electroconductive metal paste of the logic component are provided on the ceramic substrate preferably in one process step (i.e., at the same time) which facilitates the production of the logic power module according to the present invention. In this case, the same compositions are printed once on the entire surface of the ceramic substrate in the area of the power components and usually discontinuously in the area of the logic component in order to create the intelligent structures such as, inter alia, conductors, die attach structures (on, for examples, chips are provided), and passive electronic components, such as resistors, capacitors. The drying and sintering, preferably firing, process steps can be carried out also at the same time under the same conditions for both pastes in the logic and power component.

### Example section

The present invention is described in more detail with regard to the following examples:
A thick-film paste material is prepared starting from the following glass composition (in wt.-%):

| Glass | d₅₀ (µm) | Tg (DSC, °C) | SiO₂ | ZnO | B₂O₃ | Al₂O₃ | TiO₂ | CaO | K₂O | MgO | Na₂O | ZrO₂ | Li₂O |
|---|---|---|---|---|---|---|---|---|---|---|---|---|---|
| A | 2,6 | 744 | 38 | 0.2 | 3.9 | 19.5 | 2.4 | 35.9 | 0.1 | 0 | 0 | 0.1 | 0 |
| B | 3,6 | 677 | 27.3 | 3.9 | 10.5 | 24.7 | 3.5 | 25.9 | 0 | 3.21 | 0.8 | 0 | 0 |
| C | 2,8 | 584.6 | 61.2 | 0.5 | 9.0 | 3.3 | 6.4 | 8.8 | 6.5 | 0.5 | 2.8 | 0 | 0.6 |

### Vehicle formulation

| Texanol [wt%] | Butyl diglyme | Acrylic resin |
|---|---|---|
| 43 | 23 | 34 |

### Paste formulation

| Paste | Cu powder [wt%] (d₅₀ of 4.7 µm) | Glass type; [wt%] | Vehicle [wt%] | Bi₂O₃ [wt%] (d₅₀ of 4.3 µm) |
|---|---|---|---|---|
| A | 86 | A; 3 | 11 | - |
| B | 86 | B; 3 | 11 | - |
| C | 86 | C; 3 | 11 | - |
| D | 86 | - | 11 | 3 |

Starting from these paste formulations, a power component 3 on a ceramic metal substrate 4 was prepared by printing the pastes on a Al₂O₃ ceramic substrate in the area 4b of the power component 3 in a thickness of 40 µm. The pastes were dried in an oven at 110 °C for 10 min and sintered at 950 °C for 10 minutes before a Cu foil with a thickness of 300 µm was applied onto the dried pastes and the composite was fired in an oven for 150 min, whereby a peak temperature at 1040 °C for 5 minutes was reached.

For comparison, a ceramic metal substrate was prepared starting from the same ceramic substrate and the same Cu foil as for the examples with pastes, but using a standard DCB process with a bonding time of 160 min and a peak temperature in the range of 1078 °C for 4 minutes. This ceramic substrate 4 comprises an area 4b for a power component 4 prepared by a classical DCB process.

The finished metal ceramic substrates have been subject to thermal cycles (15 min at -40 °C, 15 sec. transfer time, 15 min at +150 °C). The test results can be seen in the following table.

| Metal ceramic substrate | Paste | # of thermal cycles before delamination |
|---|---|---|
| 1 | A | 1550 |
| 2 | B | 2470 |
| 3 | C | 3040 |
| 4 | D | 2850 |
| 5 | No paste, standard DCB process | 100 |

## Claims

1. A logic power module (1), comprising at least one logic component (2), at least one power component (3) and a ceramic substrate (4), whereby the logic component (2) and the power component (3) are provided in separate areas (4a, 4b) on the ceramic substrate (3),
**characterized in that**
the logic component (2) on the substrate (3) is provided by thick printed electroconductive metal paste; and
the power component (3) is provided by a metal-containing thick-film layer, and, provided thereon, a metal foil.

2. The logic power module (1) according to claim 1, **characterized in that** the thick-film layer constituting the power component (3) is prepared from a thick-film paste.

3. The logic power module (1) according to claim 1 or 2, **characterized in that** the power component (3) is provided by a continuous application of the thick-film paste on the ceramic substrate (3) and a continuous application of the metal foil on the thick-film-paste.

4. The logic power module (1) according to claim 1 or 2, **characterized in that** the power component (3) is provided by a discontinuous application of the thick-film paste on the ceramic substrate (3) and a continuous application of the metal foil on the thick-film-paste.

5. The logic power module (1) according to anyone of claims 1 to 4, **characterized in that** in the power component (3) the thick-film layer is formed by a thick-film paste which is coated onto the metal foil or the substrate by screen printing.

6. The logic power module (1) according to anyone of claims 1 to 5, **characterized in that** in the power component (3) the metal foil and/or the thick-film layer is oxidized before bonding to the substrate.

7. The logic power module (1) according to anyone of claims 1 to 6, **characterized in that** in the power component (3) the thick-film paste is applied onto the substrate or metal foil by multilayer printing.

8. The logic power module (1) according to anyone of claims 1 to 7, **characterized in that** the ceramic substrate (3) is an alumina ceramic (Al₂O₃), an aluminum nitride ceramic (AIN), a zirconia toughened alumina ceramic (ZTA), a beryllia oxide ceramic (BeO) or a Si₃N₄ ceramic.

9. The logic power module (1) according to anyone of claims 1 to 8, **characterized in that** the thick printed electroconductive metal paste of the logic component (2) has the same composition as the metal-containing thick-film paste of the power component (3).

10. A process for preparing a logic power module (1), comprising at least one logic component (2), at least one power component (3) and a ceramic substrate (4), whereby the logic component (2) and the power component (3) are provided in separate areas (4a, 4b) on the ceramic substrate (3).
**characterized in that**
the logic component (2) on the ceramic substrate (3) is prepared by screen printing, stenciling and/or direct deposition of thick printed copper; and
the power component (3) on the ceramic substrate (3) is prepared by the following process steps:
(1.1) applying of a thick-film paste onto the ceramic substrate (4);
(1.2) applying of a metal foil onto the thick-film layer of the ceramic substrate (4); and
(1.3) bonding of the metal foil with the ceramic substrate (4) via the thick-film layer. or
(2.1) applying of a thick-film paste onto a metal foil;
(2.2) applying of the ceramic substrate (4) onto the thick-film layer of the metal foil; and
(2.3) bonding the metal foil with the ceramic substrate via the thick-film layer.

11. The process according to claim 10, **characterized in that** the thick-film paste of the power component (3) is coated onto the metal foil or the ceramic substrate (4) by screen printing.

12. The process according to claims 10 or 11, **characterized in that** the metal foil and/or the thick-film layer of the power component (3) is oxidized before bonding to the ceramic substrate (4).

13. The process according to any one of claims 10 to 12, **characterized in that** the thick-film paste of the power component (3) is applied onto the ceramic substrate (4) or onto the metal foil by multilayer printing.

14. Power logic module (1) prepared according to the method of anyone of claims 10 to 13.

15. Use of a power logic module according to anyone of claim 1 to 9 or 14 in power electronic circuits.
